# EUROPEAN PATENT APPLICATION

(11) **EP 4 782 824 A1**
(43) Date of publication of application: **29.07.2026**
(21) Application number: 25197211.3
(22) Date of filing: 21.08.2025
(51) Int. Cl.: G01N 24/00, G01R 33/26

(54) **QUANTUM SENSOR DEVICE**

(30) Priority: 23.01.2025 US 202519035022
(71) Applicant: Rohde & Schwarz GmbH & Co. KG, 81671 München (DE)
(72) Inventor: Cardalda-Garcia, Adrian, 85551 Kirchheim b. München (DE); Ruster, Thomas, 81543 Munich (DE); Ho, Melvyn, 81677 Munich (DE); Wong, ChunSoong, 486041 Singapore (SG)
(74) Representative: Rupp, Christian

(57) **Abstract**

The present disclosure relates to a quantum sensor device (10), comprising at least one sensing element (11) which is formed from non-conducting materials; wherein the sensing element (11) comprises a powder of a solid material, wherein the powder comprises particles with at least a fraction of said particles comprising defects. The quantum sensing device (10) further comprises a light source (12) configured to irradiate the sensing element (11) with a light beam, wherein the sensing element (11) is optically excited by the light beam; and an optical detector (13) configured to detect an optical response of the sensing element (11); wherein the quantum sensing device (10) is configured to determine a parameter of a magnetic and/or an electromagnetic field to be analyzed based on said optical response.

## Description

### Technical Field

The present disclosure relates to a quantum sensor device for measuring magnetic and/or electromagnetic fields.

### Background Art

Many radio frequency (RF) devices, such as automotive radars and certain RF base stations, utilize wide-bandgap materials (e.g. GaN, SiC), because these material allow for a very fast current and voltage switching. However, it is challenging to accurately measure such rapidly switched currents and voltages.

Conventional measurement techniques for fast-switching currents and/or voltages often have the disadvantage of being intrusive to the circuit (thus affecting the measurement results) or not being able to measure accurately at very fast switching speeds (e.g., at 1 GHz). Two known measurement techniques, which are mostly non-intrusive to a circuit, are clamp-type and hall-effect sensors. However, these technologies, in particular clamp type sensors, can add unwanted inductive loading. Shunt resistors (resistor in parallel) are a further possible measurement technology. However, shunts are imperfect and require a high sensitivity (low currents) and resilience (high voltages).

Accordingly, there is a need to provide a sensor device which overcomes the above-mentioned disadvantages and limitations. In particular, there is a need to provide a sensor device which is capable of measuring high currents in fast switching scenarios.

### Summary

An aspect of the present disclosure relates to a quantum sensor device. The quantum sensor device comprises at least one sensing element which is formed from non-conducting materials; wherein the sensing element comprises a powder of a solid material, wherein the powder comprises particles with at least a fraction of said particles comprising defects. The quantum sensor device further comprises a light source configured to irradiate the sensing element with a light beam, wherein the sensing element is optically excited by the light beam; and an optical detector configured to detect an optical response of the sensing element; wherein the quantum sensor device is configured to determine a parameter of a magnetic and/or an electromagnetic field to be analyzed based on said optical response.

This achieves the advantage that a sensor device is provided which can measure magnetic and/or EM fields in a highly accurate and non-intrusive manner. For example, the sensor can measure the strength of a magnetic field which is caused by an electrical current through a wire. The current can then be deduced from the magnetic field strength. Furthermore, the sensor device does not affect the field to be measured in an unwanted way, due to the sensing element being comprised of nonconductive materials (non-intrusive measurement).

Furthermore, the particles of the powder (or a fraction thereof) comprising defects leads to a uniform optical response to the magnetic and/or the electromagnetic field. This is due to the varying orientation of the powder particles and thus the defects in the sensing element.

In an implementation form, the defects are directional defects, wherein the particles of the powder are arranged in varying orientations causing a uniform optical response to the magnetic and/or the electromagnetic field to be analyzed upon irradiating the sensing element with the light beam.

Preferably, the sensing element has no directivity due to the varying (e.g., random) orientation of the directional defects. Thus, the sensor element does not have to be aligned to a direction of the field to be measured, which greatly facilitates the measurement.

In an implementation form, the powder is a diamond powder.

For example, the defects are nitrogen-vacancy center (NV) defects.

These NV defects can have atom-like properties. For instance, the defects can be in a ground state or an excited quantum state, depending on an excitation. The defects can be optically excited from the ground state to the excited state by the light beam.

The magnetic and/or an electromagnetic field to be analyzed can permeate the sensing element and, in this way, affect the optical response in a measurable manner. For example, a processor of the quantum sensor device is configured to analyze the optical response and determine the parameter of the magnetic and/or electromagnetic field.

In an implementation form, the optical response is an emission of light by the powder; wherein the optical detector is configured to measure an intensity of the emitted light; and wherein the quantum sensor device is configured to determine the parameter of the magnetic and/or electromagnetic field based on said intensity.

In an implementation form, the field to be analyzed is a magnetic field which is caused by an electrical current; and the quantum sensor device is configured to determine a characteristic of the current based on the parameter of the magnetic field. This achieves the advantage that a current can be efficiently measured via a measurement of the associated B-field. The current can be a fast-switching and/or a high current. The characteristic of the current can comprise an amplitude of the current and/or a switching frequency.

In an implementation form, the quantum sensor device further comprises a trace or a wire which carries the electrical current. The magnetic field can be induced by the current flowing through the trace or wire.

For example, the trace or wire is straight (at least in sections) and is arranged in close proximity to the powder, such that the powder is permeated by and can thus efficiently measure the magnetic field caused by the current.

In an implementation form, the quantum sensor device comprises at least two of the sensing elements which are arranged at a certain distance and/or orientation from each other. This achieves the advantage that a directional sensing can be realized, by measuring the field to be analyzed at two known locations (e.g., at two distances from a device under test which emits the field).

In an implementation form, the quantum sensor device comprises at least one further sensing element which comprises a solid diamond with directional defects; wherein the at least one sensing element and the at least one further sensing element are arranged at a certain distance and/or orientation from each other. This achieves the advantage that a directional sensing can be realized. For example, the solid diamond comprises NV defects.

In an implementation form, the quantum sensor device comprises a control unit which comprises or is communicatively connected to the light source and/or the optical detector.

The control unit can be configured to control the light source and/or the optical detector. The control unit can be a base unit.

In an implementation form, the control unit comprises at least one optical interface, wherein the control unit is configured to read-out and/or control the quantum sensor via the optical interface.

For instance, the control unit is configured to receive the optical response of the sensing element via the optical interface and to forward this response to the optical detector.

In an implementation form, the control unit comprises a display element which is configured to display a measurement result. The display element can be a data display.

In an implementation form, the control unit is an oscilloscope.

In an implementation form, the quantum sensor device comprises a measurement probe; wherein the at least one sensing element is arranged in the measurement probe. For example, the control unit is arranged external to the measurement probe and is connected to the measurement probe via at least one cable.

The measurement probe can be a portable probe. The light source and/or the optical detector can be arranged in the portable probe or external to the portable probe (e.g., in the housing of the control unit).

In an implementation form, the measurement probe comprises an optical waveguide which is enriched with the powder. For instance, this allows to efficiently illuminate the powder (e.g., a diamond powder) with the light beam and/or to read out the optical response of the powder (i.e., by means of the waveguide, light can be guided from the light source to the powder and/or light emitted by the powder can be guided to the optical detector). For example, the powder is arranged in or on the optical waveguide.

The measurement probe may further comprise two optical connections to connect the waveguide with the control unit and/or the optical detector.

### Brief Description of the Drawings

Exemplary embodiments of the disclosure are now further explained with respect to the drawings by way of example only, and not for limitation. In the drawings:
Fig. 1 shows a schematic diagram of a quantum sensor device according to an embodiment; and
Fig. 2 shows a schematic diagram of a current measurement with a quantum sensor device according to an embodiment.

### Detailed Descriptions of Embodiments

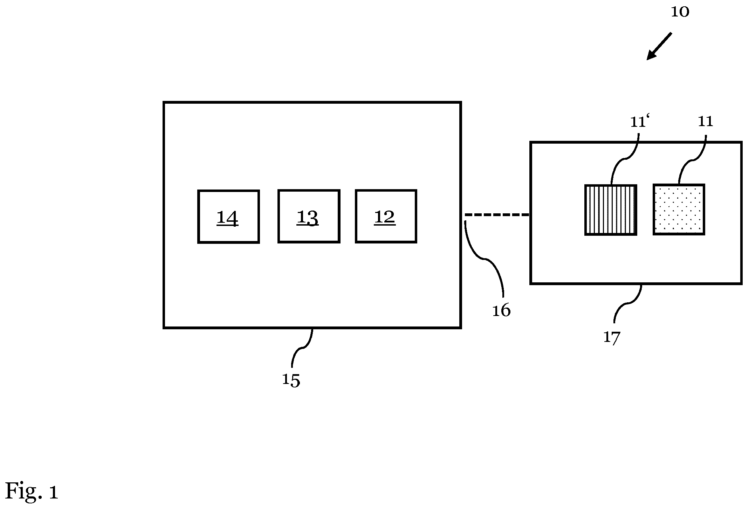

Fig. 1 shows a schematic diagram of a quantum sensor device 10 according to an embodiment. The quantum sensor device 10 comprises at least one sensing element 11 which is formed from non-conducting materials; wherein the sensing element 11 comprises a powder of a solid material, wherein the powder comprises particles with at least a fraction of said particles comprising defects. The quantum sensor device 10 further comprises a light source 12 configured to irradiate the sensing element 11 with a light beam, wherein the sensing element 11 is optically excited by the light beam; and optical detector 13 configured to detect an optical response of the sensing element 11; wherein the quantum sensor device 10 is configured to determine a parameter of a magnetic and/or an electromagnetic field to be analyzed based on said optical response.

The defects can comprise directional defects. In general, directional defects are a type of crystallographic defect in solid materials where the regular arrangement of atoms is disrupted along a line within the crystal structure. Directional defects extend in a specific direction through the material and are thus different from, e.g., point defects. In addition, at least some of the powder particles could comprise other types of defects.

The powder can comprise a large number of the powder particles which are, e.g., in the micrometer range (or smaller). These particles can be randomly arranged in the sensing element, causing a varying, in particular random, distribution of the orientations of the directional defects in the sensing element. This random distribution of the defects may lead to a uniform optical response of the sensing element to the magnetic and/or electromagnetic field to be analyzed upon irradiating the sensing element with the light beam.

The solid material can be diamond. Thus, the powder can be a diamond powder and the powder particles can be diamond particles.

For example, the directional defects in the diamond particles are nitrogen-vacancy center (NV) defects.

These NV defects can have atom-like properties and can form a quantum system. For instance, the defects can be in a ground state or an excited quantum state, depending on an excitation. The defects may be optically excited from the ground state to the excited state by the light beam. In particular, the sensing element 11 being optically excited by the light beam may refer to at least a portion of the defects forming the quantum system being optically excited.

After being optically excited, the defects can transition back to a ground state and thereby emit a light. This light can be detected by the optical detector 13. Characteristics of the emitted light can be affected by the magnetic and/or electromagnetic field which permeates the sensing element. This can be used to determine properties of the field (e.g., the field strength).

The randomly varying orientation of the particles (and thus the directional defects) brings several advantages, in particular over a conventional quantum sensor with a solid NV diamond: When used as a quantum sensor, a solid diamond with NV defects is typically illuminated with light and exposed to a microwave radiation in order to excite the resonances in the NV defects in a way that is suitable for readout. This readout is then typically performed by recording a spectrum of light emitted by the defects and detecting the relative distance of two peaks in the spectrum. In contrast, a quantum sensor device 10 with e.g. a diamond powder, as shown in Fig. 1, only requires an optical excitation by the light source 12 and typically no additional microwave radiation in order to generate suitable excited states. A read-out of the sensor device 10 can be carried out by measuring an intensity of light which is emitted by the diamond powder. This intensity directly correlates to a strength of the magnetic or EM field to be measured. Thus, no spectrum needs to be recorded which makes the readout of the sensor less complex.

Furthermore, as a consequence of the random distribution of the powder particles (and thus the directional defects), the sensing element 11 has no directivity towards the field to be measured. This means that e.g. a magnetic field to be measured does not have to be aligned to the direction of the defects, which facilitates the measurement.

A further advantage of this sensing element 11 is the fact that it has essentially no conductive components. Thus, the sensing element 11 does not affect the field to be measured in an unwanted way (non-intrusive measurement).

The light source 12 can comprise at least one laser. The optical detector 13 can be a photodiode.

The sensing element 11 can comprise a sensing volume which contains the powder.

For example, the quantum sensor device 10 is configured to determine a parameter of the magnetic and/or the electromagnetic field based on the optical response of the sensing element 11. The optical detector 13 can therefore be configured to measure the intensity of light emitted by the sensing element 11 in response to the optical excitation; and the quantum sensor device 10 can be configured to determine the parameter of the magnetic and/or the electromagnetic field based on said intensity. The parameter can be a strength or amplitude of the field to be analyzed. For example, the quantum sensor device 10 comprises a processor (e.g., a microprocessor) which is configured to determine the parameter of the magnetic and/or the electromagnetic field based on the detected light intensity.

The quantum sensor device 10 may comprises at least two of the sensing elements 11 which are arranged at a certain distance and/or orientation from each other. Both sensing elements 11 can be optically excited and read-out in the same way by the at least one light source 12 and optical detector 13. In this way, a directional sensing of a magnetic and/or EM field can be realized by measuring the field at the two known locations of the sensing elements 11 (e.g., at two distances from a device that emits the field).

In addition or alternatively, the quantum sensor device 10 may comprise at least one further sensing element 11' which comprises a solid diamond (i.e., not in a powder form) with directional defects (e.g., NV defects). The at least one sensing element 11 and the at least one further sensing element 11' can be arranged at a certain distance and/or orientation from each other. By means of the further sensing element 11', a directional information could be recorded, while the powder-based sensing element 11 could record a strength of the magnetic and/or EM field to be analyzed. For example, the further sensing element 11' comprises a small NV diamond.

As shown in Fig. 1, the quantum sensor device 10 can comprise a control unit 15. The control unit 15 can be a base unit which is external to a measurement probe 17 that contains the sensing element 11 and/or the further sensing element 11'. Alternatively, the control unit 15 could also be arranged in the same housing as the probe 17.

The control unit 15 can comprises the light source 12 and/or the optical detector 13. Alternatively, these components 12, 13 could also be external to the control unit 15 and communicatively connected to the control unit 15.

The control unit 15 may comprise at least one optical interface 16 and can be configured to read-out and/or control the sensing element 11 (and/or the further sensing element 11') via said optical interface 16. For instance, the control unit 15 is configured to receive the optical response from the quantum sensor element(s) 11, 11' via the optical interface 16 and forward that response to the optical detector 13. The control unit 15 could further forward the optical excitation signal from the light source 12 to the sensing element(s) 11, 11' via the interface 16.

The control unit 15 can further comprise a display element 14 (e.g., a data display) which is configured to display a measurement result. The measurement result can be a determined parameter of the magnetic and/or electromagnetic field to be analyzed, or a characteristic of a current which produces the magnetic field.

For example, the control unit 15 is an oscilloscope, which may comprise or be connected to respective components (e.g., a laser) to generate optical signals and control commands to control the sensing element(s) 11, 11'.

The sensing element(s) 11, 11' can be arranged in a measurement probe 17. The measurement probe 17 could be a handheld probe.

If the light source 12 and/or the optical detector 13 are not arranged in the control unit 15, they could be arranged in the measurement probe 17.

The measurement probe 17, in particular the section which comprises the sensing element 11, can be ring-shaped or formed by single point. The powder (e.g., a diamond powder) could be used to coat a surface in the probe 17.

In an example, the measurement probe 17 comprises an optical waveguide which is enriched with the diamond powder. For instance, the diamond powder can be at least partially arranged in or on the optical waveguide. This can facilitate the illumination of the diamond powder with the light beam and/or the read-out of the optical response of the diamond powder. The optical waveguide can be arranged in the probe head of the measurement probe 17.

The measurement probe 17 may further have two optical connections to connect the waveguide to the control unit 15. For instance, the at least one optical interface 16 of the control unit 15 can be connected to the optical connections of the probe 17.

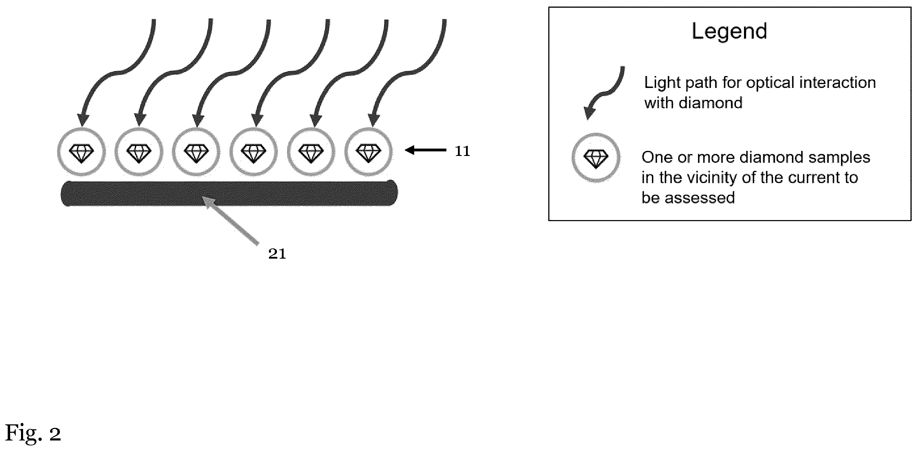

Fig. 2 shows a schematic diagram of a current measurement with the quantum sensor device 10 according to an embodiment.

As shown in Fig. 2, the field to be analyzed can be a magnetic field which is produced by an electrical current that runs through a trace or a wire 21.

The quantum sensor device 10 can be configured to determine a parameter (or characteristic) of the current in the trace or wire 21 (e.g., an amplitude and/or switching frequency of the current) based on a parameter of the magnetic field (e.g., the field strength). The parameter of the magnetic field can be determined based on the detected optical response of the sensing element 11, as explained above. For example, a processor of the sensor device 10, which determines the parameter of the magnetic field, also determines the parameter / characteristic of the current. This processor can be a component of the control unit 15.

The trace or wire 21 could be a component of the quantum sensor device 10. For example, the trace or wire 21 is arranged in close proximity to the powder, such that the powder can efficiently measure the magnetic field caused by the current.

By means of the powder-based sensing element 11, a high and/or fast switching current (e.g., 1 MHz or above) through the trace or wire 21 can be measured. Due to the fact that the sensing element is formed from non-conducting materials, the sensing element is un-intrusive and does not influence the field to be measured. For example, the sensing elements 11 being essentially free of conductive elements prevents the formation of unwanted eddy currents.

At the same time, the quantum sensor device 10 can be relatively cost-effective to fabricate and of low complexity, e.g., compared with conventional diamond powder-based quantum sensors. For example, the quantum sensor device 10 is a quantum field sensor.

In addition to a magnetic field, which is e.g. caused by a current, the sensor device 10 can also measure certain electromagnetic fields. Thereby, the highest frequency of an EM field which can be measure with the sensor may be limited by a decay time of a resonant state of the NV defects. For instance, the sensing element is fast enough to measure an EM field at 10 MHz.

In addition, the quantum sensor device 10 could at least indirectly measure other physical quantities which affect the optical response of the powder. An example for such a physical quantity is a temperature in the environment of the sensing element 11.

While various embodiments of the present disclosure have been described above, it should be understood that they have been presented by way of example only, and not limitation. Numerous changes to the disclosed embodiments can be made in accordance with the disclosure herein, without departing from the spirit or scope of the disclosure. Thus, the breadth and scope of the present disclosure should not be limited by any of the above-described embodiments. Rather, the scope of the disclosure should be defined in accordance with the following claims and their equivalents.

Although the disclosed embodiments have been illustrated and described with respect to one or more implementations, equivalent alterations and modifications will occur or be known to others skilled in the art upon the reading and understanding of this specification and the annexed drawings. In addition, while a particular feature of the present disclosure may have been disclosed with respect to only one of several implementations, such feature may be combined with one or more other features of the other implementations as may be desired and advantageous for any given or particular application.

## Claims

1. A quantum sensor device (10), comprising:
at least one sensing element (11) which is formed from non-conducting materials;
wherein the sensing element (11) comprises a powder of a solid material, wherein the powder comprises particles with at least a fraction of said particles comprising defects;
a light source (12) configured to irradiate the sensing element (11) with a light beam, wherein the sensing element (11) is optically excited by the light beam; and
an optical detector (13) configured to detect an optical response of the sensing element (11);
wherein the quantum sensing device (10) is configured to determine a parameter of a magnetic and/or an electromagnetic field to be analyzed based on said optical response.

2. The quantum sensing device (10) of claim 1,
wherein the defects are directional defects, wherein the particles of the powder are arranged in varying orientations causing a uniform optical response to the magnetic and/or the electromagnetic field to be analyzed upon irradiating the sensing element (11) with the light beam.

3. The quantum sensing device (10) of claim 1 or 2,
wherein the powder is a diamond powder.

4. The quantum sensing device (10) of claim 3,
wherein the defects are nitrogen-vacancy center, NV, defects.

5. The quantum sensing device (10) of any of the preceding claims,
wherein the optical response is an emission of light by the powder;
wherein the optical detector (13) is configured to measure an intensity of the emitted light; and
wherein the quantum sensing device (10) is configured to determine the parameter of the magnetic and/or the electromagnetic field based on said intensity.

6. The quantum sensing device (10) of any of the preceding claims,
wherein the field to be analyzed is a magnetic field which is caused by an electrical current;
wherein the quantum sensing device (10) is configured to determine a characteristic of the electrical current based on the parameter of the magnetic field.

7. The quantum sensing device (10) of claim 6, further comprising:
a trace or a wire which carries the electrical current.

8. The quantum sensing device (10) of any of the preceding claims,
wherein the quantum sensing device (10)comprises at least two of the sensing element (11)s which are arranged at a certain distance and/or orientation from each other.

9. The quantum sensing device (10) any of the preceding claims, comprising:
at least one further sensing element (11) which comprises a solid diamond with directional defects;
wherein the at least one sensing element (11) and the at least one further sensing element (11) are arranged at a certain distance and/or orientation from each other.

10. The quantum sensing device (10) any of the preceding claims, further comprising:
a control unit (15) which comprises or is communicatively connected to the light source (12) and/or the optical detector (13).

11. The quantum sensing device (10) of claim 10,
wherein the control unit (15) comprises at least one optical interface; and
wherein the control unit (15) is configured to read-out and/or control the quantum sensor via the optical interface.

12. The quantum sensing device (10) of claim 10 or 11,
wherein the control unit (15) comprises a display element (14) which is configured to display a measurement result.

13. The quantum sensing device (10) of any of claims 10 to 12,
wherein the control unit (15) is an oscilloscope.

14. The quantum sensing device (10) any of the preceding claims, comprising:
a measurement probe (17);
wherein the at least one sensing element (11) is arranged in the measurement probe (17).

15. The quantum sensing device (10) of claim 14,
wherein the measurement probe (17) comprises an optical waveguide which is enriched with the powder.
